# EUROPEAN PATENT APPLICATION

(11) **EP 1 180 742 A1**
(43) Date of publication of application: **20.02.2002**
(21) Application number: 01116707.9
(22) Date of filing: 17.07.2001
(51) Int. Cl.: G06K 1/12, G06K 15/00, G06F 13/00, G11C 16/00, G06F 12/02

(54) **System and method for reprogramming individual items in a barcode printer's flash memory**

(30) Priority: 11.08.2000 US 637719
(71) Applicant: Monarch Marking Systems, Inc., Miamisburg, Ohio 45342 (US)
(72) Inventor: Brazier, Gary Everding, Brookville, OH 45309 (US); Toth, Timothy Victor, Dayton, OH 45440 (US)
(74) Representative: von Hellfeld, Axel, Dr. Dipl.-Phys.

(57) **Abstract**

The system and method of the present invention allows the reprogramming of a flash memory in a barcode printer under the control of a host computer to permit reprogramming of selected, individual items in the flash memory without the need to reprogram items that can be changed but are to remain unchanged. The host computer operating in accordance with a control program communicates to the barcode printer a number of commands executable by the printer for reprogramming selected items including an application file, a font file and/or a print format file stored in the printer's flash memory. The commands include an erase command for erasing selected sectors in the flash memory of the barcode printer and a program command for reprogramming individual items in the flash memory. The barcode printer is responsive to each command as it is received for executing the command to reprogram individual items in the flash memory. After executing or attempting to execute a command, the barcode printer communicates to the host computer an acknowledgement of the command indicating a successful completion thereof or a status message if an error has occurred.

## Description

### FIELD OF THE INVENTION

The present invention is directed to a system and method for reprogramming a flash memory in a barcode printer where the flash memory stores a number of items including an application, one or more fonts and/or one or more print formats and more particularly, to a system and method wherein the programming is controlled by a host computer in communication with the barcode printer to allow reprogramming of selected, individual items stored in the flash memory without the need to reprogram items that are to remain unchanged.

### BACKGROUND OF THE INVENTION

Barcode printers are known that include a non-volatile storage device in the form of a flash read only memory. The flash memory is used to store the printer's firmware which may include application software, information defining one or more fonts and information defining one or more print formats. The applications, fonts and formats are stored in an area of the flash memory that can be erased and reprogrammed. A firmware application referred to as resident loader is also stored in the flash memory, but in an area that is never erased or modified.

In order to flash or reflash, i.e. program or reprogram, a flash memory in known barcode printers, the resident loader receives an image of a transient loader application from a host computer that is in communication with the barcode printer. Upon receipt of the transient loader by the barcode printer, the resident loader stores the transient loader in a random access memory (RAM) and then jumps to run the transient loader. Upon start-up, the transient loader erases the entire flash memory except for the resident loader and then waits to receive information to be programmed into the flash memory. The information to be programmed is typically sent as a simple, serial data stream from a host computer such as a personal computer or the like. The data is sent by the host computer without interpretation or modification from an image file. The serial data is programmed as it is received. The operation is complete when an end of record indication is sent to the transient loader. In known systems, the transient loader is the master of the programming process and it alone has knowledge of the organization of the image in the flash memory. Further, the transient loader works autonomously. It is not under the control of the host computer. Moreover, the functions of known transient loaders are fixed and limited. Heretofore, if a single item stored in the flash memory is to be updated, the items that are to remain unchanged have to be retransmitted and reprogrammed with the new item.

### BRIEF SUMMARY OF THE INVENTION

In accordance with the present invention, the disadvantages of prior systems and methods for reprogramming a flash memory in a barcode printer have been overcome. The system and method of the present invention reprograms the flash memory in a barcode printer under the control of a host computer to allow reprogramming of selected, individual items in the flash memory without the need to reprogram items that can be changed but are to remain unchanged.

More particularly, the host computer, operating in accordance with a control program communicates to the barcode printer a number of commands executable by the barcode printer for reprogramming selected items in the flash memory including an application, a font and/or a format. The commands include an erase command for erasing selected sectors in the flash memory of the barcode printer and a program command for reprogramming individual items in the flash memory without the need to reprogram items that can be changed but are to remain unchanged. The barcode printer is responsive to each command as it is received for executing the command to reprogram individual items in the flash memory. After executing or attempting to execute a command, the barcode printer communicates to the host computer an acknowledgement of the command indicating a successful completion thereof or a status message if an error has occurred.

In a preferred embodiment, an erase command identifies a starting address in the flash memory at which erasing is to begin and information representing an amount of the flash memory to be erased. Further, in a preferred embodiment, the host computer communicates a number of program commands to reprogram an individual item in the flash memory where each command includes a starting address and a segment of new data defining the individual item to be programmed in the flash memory beginning at the starting address. The host computer is capable of communicating a number of other commands that are executable by the barcode printer operating in accordance with a loading application so as to allow for enhanced capabilities to enable reprogramming to be accomplished more easily and to allow verification of the memory and/or programming operation.

The system and method of the present invention allows greater flexibility in reprogramming a flash memory in a barcode printer than has heretofore been possible. The programming operation itself is much more efficient since only those sections of the flash memory that need to be updated are reprogrammed as opposed to the entire area of the flash memory that can be reprogrammed. The loading program according to which the barcode printer operates is generic and has no proactive functions so that it is in essence a slave to the host computer in the reprogramming operation. Because the controlling operations reside in the host computer control program, the system and method of the present invention provide a much more powerful platform for development of new features in the barcode printer. Moreover, the combination of the command structure and message protocol provides a high degree of fault tolerance to communication errors so that many errors that might occur during the flashing operation are recoverable. Further, the command/acknowledge nature of the communication protocol between the host computer and the barcode printer during reprogramming allows for faster communication speeds and reduced re-flashing times. These and other advantages and novel features of the present invention, as well as details of an illustrated embodiment thereof, will be more fully understood from the following description and drawings.

### BRIEF DESCRIPTION OF THE SEVERAL VIEWS OF THE DRAWINGS

Fig. 1 is a perspective view of a barcode printer which operates in accordance with the loading program of the present invention;
Fig. 2 is a block diagram of the portable barcode printer shown in Fig. 1 and in communication with a host computer;
Fig. 3 is a flow chart illustrating the main loading program of the barcode printer;
Figs. 4A-B form a flow chart illustrating a process command routine of the loading program of Fig. 3;
Figs. 5A-B form a flow chart illustrating the main control program according to which the host computer operates to reprogram the barcode printer's flash memory;
Fig. 6 is a flow chart illustrating a read printer's primary flash directory routine as shown in Fig. 5A;
Fig. 7 is a flow chart illustrating a process file list routine as shown in Fig. 5A;
Fig. 8 is a flow chart illustrating an erase all storage routine as shown in Fig. 7;
Figs. 9A-9B form a flow chart illustrating an erase item storage routine as shown in Fig. 7;
Fig. 10 is a flow chart illustrating a process application file routine as illustrated in Fig. 7;
Fig. 11 is a flow chart illustrating an erase application image routine as shown in Fig. 10;
Fig. 12 is a flow chart illustrating a program application image as shown in Fig. 10;
Fig. 13 is a flow chart illustrating a process font file routine as shown in Fig. 7;
Fig. 14 is a flow chart illustrating a process format file routine as shown in Fig. 7; and
Fig. 15 is a flow chart illustrating a verify item routine implemented by the host computer in accordance with the control program.

### DETAILED DESCRIPTION OF THE INVENTION

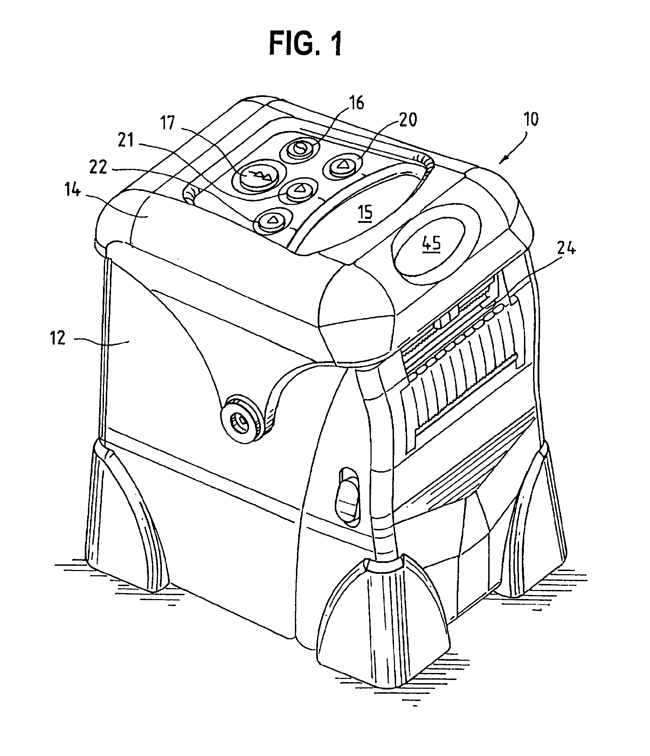

A barcode printer 10 having a reprogrammable flash memory is shown in Fig. 1 as a portable printer that prints barcodes and/or alphanumeric characters on a web of record members such as labels, tags or other printer supply material contained in a printer housing 12. The housing 12 includes a top cover on which is mounted a display 15 and a set of function keys 16, 17, 20, 21 and 22. The function key 16 may be, for example, an on/off switch. The key 17 is a feed key that is used to advance the web of record members through the printer past a printhead contained therein so that the label exits an opening 24 in the housing after the desired information is printed thereon. Each of the keys 20-22 is a variable function key. Each variable function key 20-22 is associated with a large number of functions that are identified by the display 15.

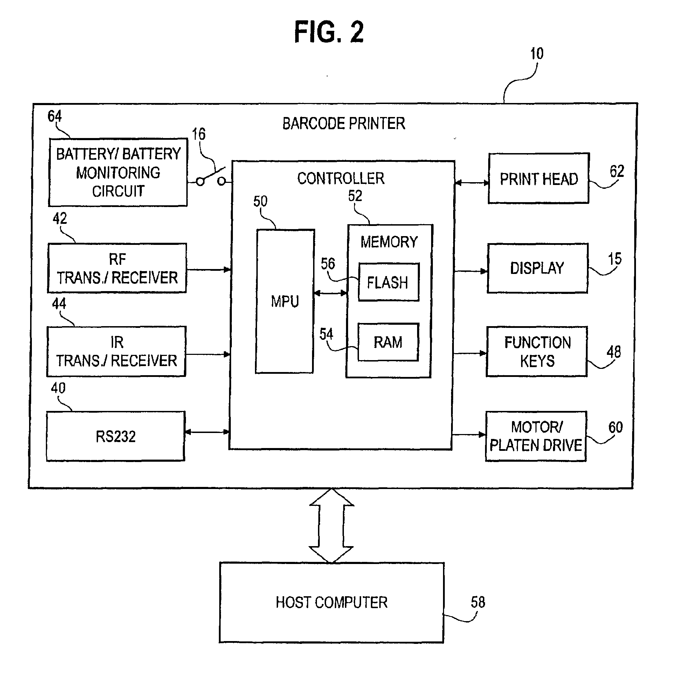

The barcode printer 10 may be, for example, an on-line printer in which print data is received from an external device such as a data collector and/or a remote host computer. As shown in Fig. 2, the barcode printer 10 may receive the print data via a hard wired connection such as RS 232 communication port 40. Alternatively, the barcode printer 10 may receive the print data via wireless communications. For example, the barcode printer 10 may include a radio frequency (RF) communication interface with a transmitter and receiver 42. Alternatively, or in addition thereto, the barcode printer 10 can utilize an infra-red (IR) communication interface 44. If infra-red communications are employed, the housing 12 of the barcode printer includes a window 45 through which the IR transmissions can pass. Because the barcode printer 10 is an on-line printer, receiving print data from an external device, the printer does not need a full-size keyboard for data entry. However, it should be appreciated, that the system and method of the present invention for reprogramming a flash memory can be utilized by an off-line barcode printer having a full-size keyboard for data entry as well. The barcode printer merely has to be capable of communicating with a host computer for reprogramming the flash memory as described in detail below.

The barcode printer 10 includes a controller with at least one microprocessor 50 that operates in accordance with application software stored in a flash ROM 56. The flash ROM 56 also preferably stores one or more fonts and one or more formats as well. The flash memory 56 preferably includes two sections. One section storing a resident loader which cannot be modified and another area of the flash ROM storing application files, font files and print format files that can be reprogrammed. The memory 52 of the controller also includes a random access memory (RAM) 54 used as a scratch pad memory and for storing print data received from an external host device 58 that is in communication with the barcode printer 10. The host device may be, for example a host computer such as a P.C., i.e. a personal computer. The RAM 54 is also used to store a loading application or program referred to as a transient loader as discussed in detail below. In response to the print data and an on-line print command, the microprocessor 50 controls a motor 60 coupled to a platen through a platen drive mechanism so as to drive the platen and thereby feed the web of record members past the printhead 62. As the web of record members is moved past the printhead 62, the microprocessor 50 controls the printhead to print the data in a particular font and arranged in a particular print format. The barcode printer 10 is preferably powered by a battery 64 wherein the controller can monitor the battery level.

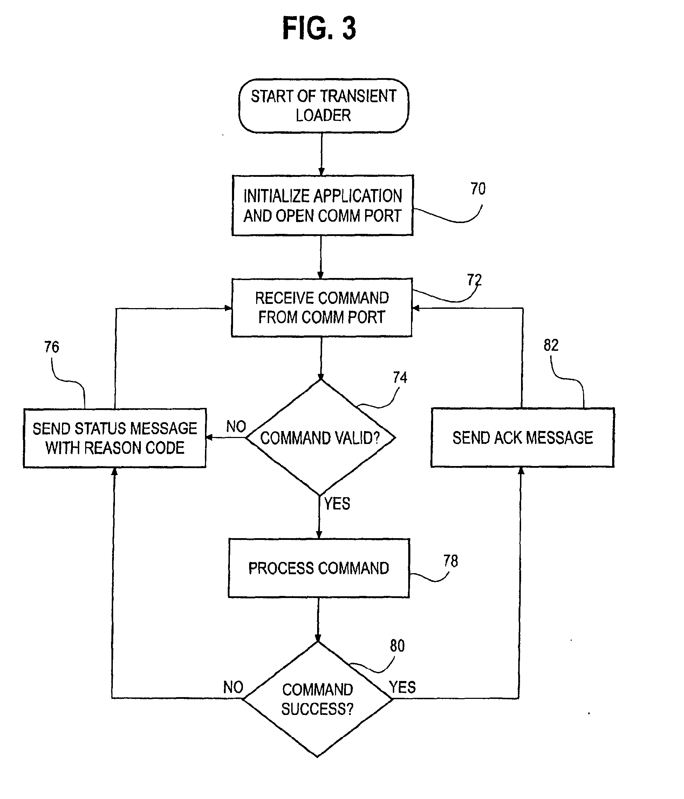

In order to program the flash memory 56, the resident loader stored in the flash memory 56 receives the transient loader application from the host computer 58. The resident loader stores the transient loader in the RAM 54 and thereafter starts the transient loader running. At the start of the transient loader as depicted in Fig. 3, the microprocessor 50 of the barcode printer 10 initializes the transient loader application and opens a communication port at block 70 so as to allow communications between the barcode printer 10 and the host computer 58. At block 72, the microprocessor 50 receives a command from the host computer and proceeds to determine whether the command is valid or not at block 74. If the command is not valid, the microprocessor 50 proceeds to block 76 to send a status message back to the host computer 58. The status message includes a code identifying the reason that the command could not be executed.

The allowable status messages may indicate one of the following reasons for failure to execute a command: a communications parity error has occurred; a communications framing error has occurred; a communications buffer has been overrun; the flash address included in the command is illegal; a sector count value is illegal; the RAM address included in the command is illegal; an error has occurred erasing the flash; an error has occurred writing the flash; an error has occurred writing to the RAM; a command checksum failure has occurred; a data checksum has occurred; there is a message format error; the message is too long; an invalid record type has been specified; an invalid ASCII hex data has been detected in the record; or a break in the message is too long. It should be appreciated that the status message may indicate other types of errors as well.

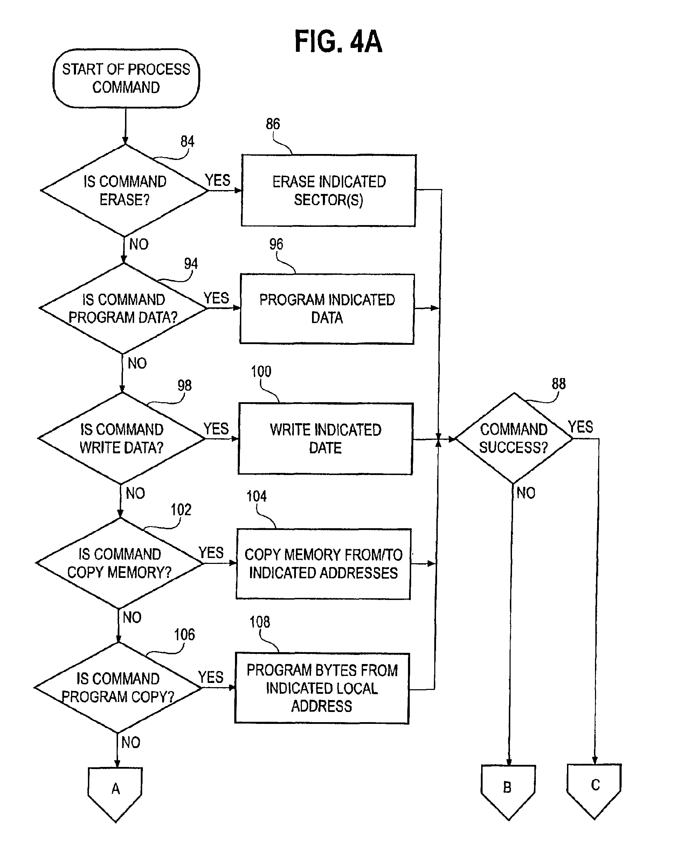

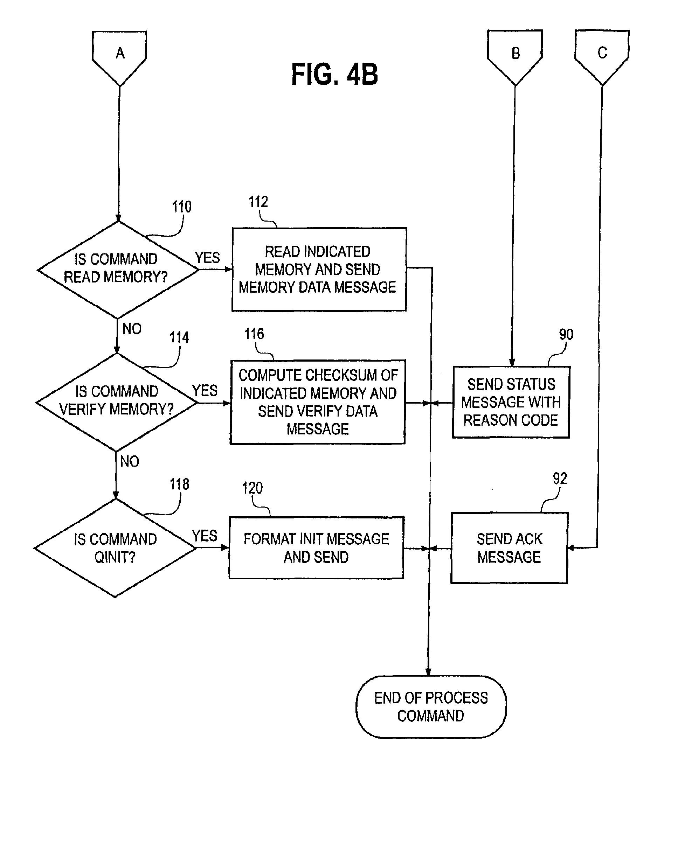

If the microprocessor 50 determines at block 74 that the command received from the host computer 58 is valid, the microprocessor 50 proceeds to block 78 to process the command as depicted in Figs. 4A-B. After processing the command, the microprocessor 50 determines at block 80 whether the command has - been successfully executed and if not, the microprocessor proceeds to block 76 to send an appropriate status message indicating the reason for the error. If the microprocessor 50 determines at block 80 that the command has been successfully executed by the barcode printer 10, the microprocessor 50 proceeds to block 82 to send an acknowledge message back to the host computer 58.

The microprocessor 50 of the barcode printer 10 processes the various commands received from the host computer 58 in accordance with the flow chart depicted in Figs. 4A-B. At a block 84, the microprocessor 50 determines whether the received command is an erase command. The erase command includes a starting address in the flash memory at which erasing is to begin as well as the number of sectors to be erased therein. Upon receipt of a valid erase command the microprocessor 50 of the barcode printer 10 proceeds from block 84 to block 86 to erase the sectors in the printer's flash memory 56 as indicated in the erase command. From block 86, the microprocessor 50 proceeds to block 88 to determine whether the erase command was successfully executed. If the erase command was successfully executed, the microprocessor proceeds to block 92 to send an acknowledge message back to the host computer 58. If the microprocessor determines at block 88 that the command could not be successfully executed, the microprocessor 50 proceeds to block 90 to send the appropriate status message back to the host computer 58 indicating the reason that the erase command could not be successfully executed.

The microprocessor 50 at block 94 determines whether the command received from the host computer 58 is a program data command. The program data command is used to program data into the flash memory 56 of the barcode printer 10. The program data command identifies the starting address in the flash memory at which programming is to begin, the number of data bytes included in the program data command, an 8 bit checksum for the command sub-packet excluding the value indicating the start of a packet, a value that signals the start of the data portion of the command packet followed by the data to be programmed into the flash memory, high order and low order checksum bytes and an end of record or message indicator. If the microprocessor determines that a valid program data command has been received from the host computer 58, the microprocessor 50 proceeds from block 94 to block 96 to program the data contained in the program data command into the flash memory 56. Thereafter, the microprocessor proceeds to block 88 to determine whether the command was successfully executed or not. If the command was successfully executed, the microprocessor 50 returns an acknowledge message to the host computer 58 at block 92; otherwise a status message with an appropriate error code is returned at block 90 to the host computer 58.

The microprocessor 50 at block 98 determines whether a write data command has been received from the host computer 58. The write data command is used to write data received from the host computer 58 into the RAM 54 of the barcode printer. The format of the write data command is similar to the program data command as discussed above except that the address information indicates an address in the RAM 54 and the packet type identifies the packet as a write data command. If a valid write data command has been received, the microprocessor at block 100 writes the data contained in the write data command into the RAM 54. Thereafter, the microprocessor 50 proceeds to block 88 to determine whether the command was successfully executed or not. If the command was successfully executed, the microprocessor 50 returns an acknowledge message at block 92 back to the host computer 58; otherwise, a status message with an appropriate error code is returned to the host computer at block 90.

The microprocessor 50 at block 102 determines whether the command received from the host computer 58 is a copy memory command. The copy memory command is used to copy data from one location in one of the printer's memories 54 or 56 to a location in the RAM 54 identified in the copy memory command. The copy memory command includes the starting source address for the data to be copied, i.e. the starting address in one of the printer's memories at which the data to be copied begins; the number of bytes to be copied beginning at the source address and a destination address identifying the starting address in the RAM 54 at which the copied data is to be stored. If a valid copy memory command has been received, the microprocessor 50 proceeds from block 102 to block 104 to copy the number of bytes indicated in the command beginning at the indicated starting source address to the indicated destination address in the RAM 54. From block 104, the microprocessor 50 proceeds to block 88 to determine whether the copy memory command was successfully executed. If the command was successfully executed, the microprocessor 50 proceeds to block 92 to return the acknowledge message back to the host computer; otherwise, the microprocessor 50 sends back an appropriate status message at block 90.

The microprocessor 50 at block 106 determines whether the command received from the host computer 58 is a program copy command. A program copy command is used to program an indicated number of bytes from a specified address in one of the printer's memories to a specified destination address in the printer's flash memory 56. The program copy command includes the starting source address, the number of bytes to be programmed into the flash memory 56 and the destination address in the flash memory 56 which is the starting address at which the data is to be programmed in the flash memory. If a valid program copy command has been received, the microprocessor 50 proceeds from block 106 to block 108 to program the indicated number of bytes of data from the source address to the flash memory 56 beginning at the designated destination address. From block 108, the microprocessor 50 proceeds to block 88 to determine whether the program copy command was successfully executed or not. If the command was successfully executed, the microprocessor 50 at block 92 sends an acknowledge message back to the host computer 58; otherwise, a status message is sent at block 90 including the appropriate error code.

The microprocessor 50 at block 110 determines whether the command that has been received from the host computer 58 is a read memory command. The read memory command is used to retrieve the contents of any memory in the printer 10 so that it can be sent back to the host. The read memory command includes the starting address and the number of bytes beginning at the starting address to be retrieved. If a valid read memory command is received, the microprocessor 50 proceeds from block 110 to block 112 to read the designated number of bytes from the memory beginning at the specified starting address. At block 112, the microprocessor 50 sends a memory data message back to the host computer to indicate that the read command has been successfully executed. The memory data message includes the starting address and number of bytes retrieved as indicated in the read memory command. The memory data message also includes the data bytes that have been read from the memory as well as various checksum values.

The microprocessor 50 at block 114 determines whether the command received from the host computer 58 is a verify memory command. The verify memory command is used to cause a checksum computation to be performed over a specified contents of any of the memories in the barcode printer 10. The verify memory command includes the starting address and the number of bytes in the memory for which a checksum is to be computed. If the microprocessor 50 determines that a valid verify memory command has been received, the microprocessor proceeds from block 114 to block 116 to compute a checksum of the indicated memory data. At block 116 the microprocessor 50 also sends a verify data message back to the host computer 58. The verify data message is an acknowledgement that the checksum computation has been successfully executed. The verify data message includes the address and number of memory bytes as set forth in the verify memory command so as to identify the response packet. The verify data message also includes the computed verification checksum value that was requested by the host computer 58.

The microprocessor 50 at block 118 of the barcode printer 10 determines whether the command received from the host computer 58 is the QINIT command. The QINIT command is sent at the beginning of the reprogramming process after the host computer 58 determines that the transient loader is running in the barcode printer 10. If the microprocessor 50 determines that a valid QINIT command has been received from the host computer 58, the microprocessor proceeds from block 118 to block 120 to format an INIT message that the microprocessor 50 sends back to the host computer The INIT message includes the identity of the manufacturer of the flash memory 56 and the low order byte of the device code associated with the flash memory 56. The INIT message indicates to the host computer the identity of the flash memory that is contained in the barcode printer 10 which is going to be reprogrammed.

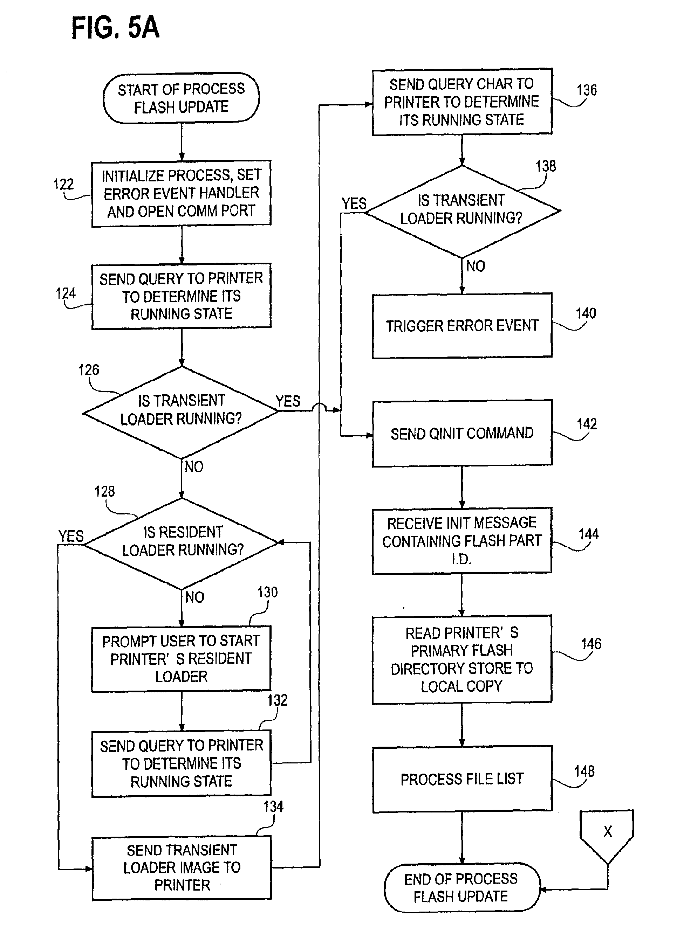

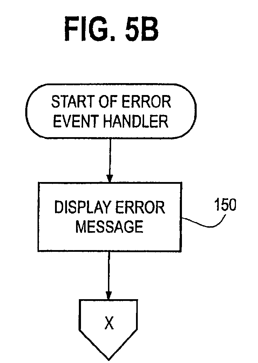

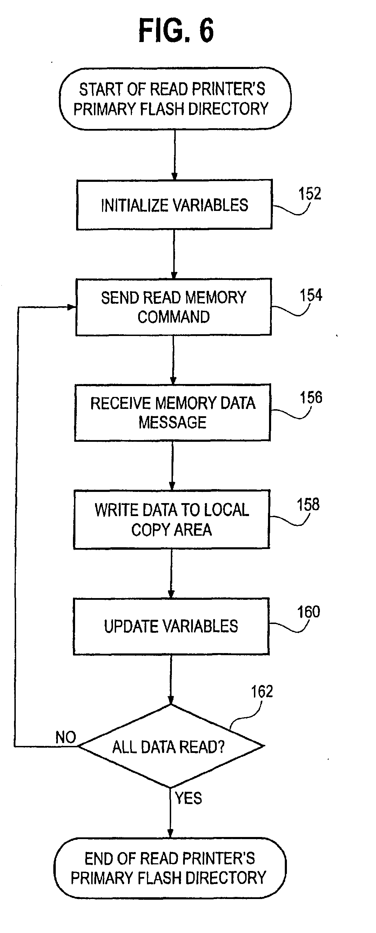

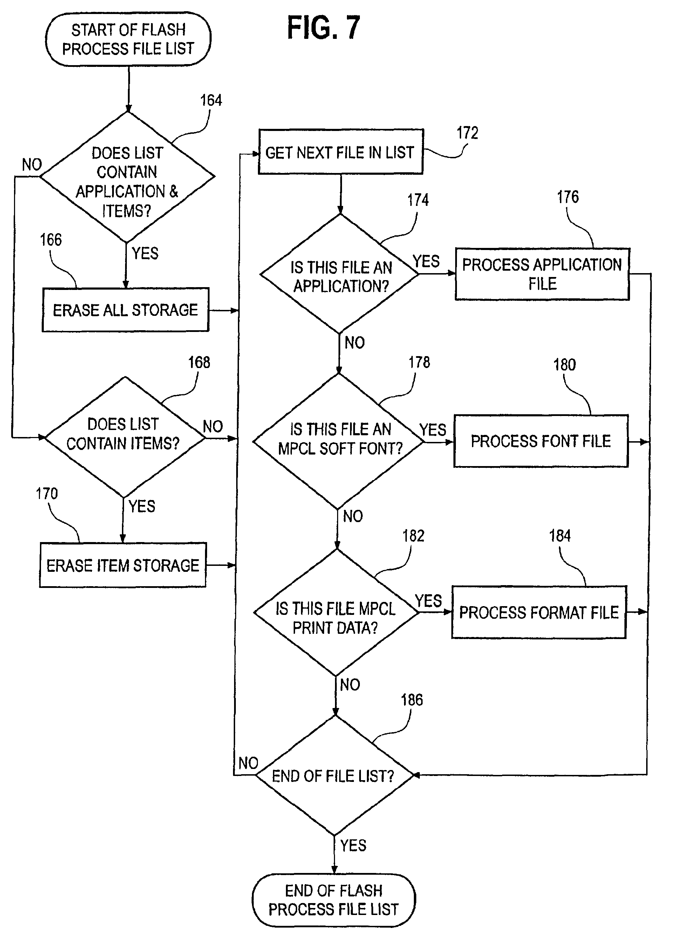

The host computer 58, which as noted above is typically a personal computer, controls the reprogramming of the flash memory 56 in the barcode printer 10 so as to reprogram individual items in the flash memory, i.e. an application file, a font file and/or a print format file, without the need to reprogram all of the items that can be changed but are to remain unchanged in accordance with a control program represented by the flow charts depicted in Figs. 5-15. The main control program is depicted in Figs. 5A-B. At the start of the control program, the host computer at block 122 initializes the flash update process, sets an error event handler and opens a communication port so as to enable communications between the host computer 58 and the barcode printer 10. Thereafter, the host computer 58 proceeds to block 124. At block 124, the host computer 58 sends a query to the barcode printer 10 to determine the printer's running state. At block 126, the host computer 58 determines whether the transient loader is running or not. If the transient loader is not running, the host computer 58 proceeds from block 126 to block 128 to determine whether the resident loader is running in the barcode printer 10. If the resident loader is not running, the host computer proceeds to block 130 to prompt a user of the host computer to start the resident loader in the barcode printer 10. Thereafter, the host computer 58 sends to the barcode printer 10 at block 132 a query to determine the running state of the printer, from block 132 the host computer 58 returns to block 128 to again determine whether the resident loader is running in the barcode printer 10. When the host computer 58 determines at block 128 that the resident loader is running in the barcode printer 10, the host computer 58 proceeds to block 134. At block 134, the host computer sends to the barcode printer 10 an image of the transient loader application. As discussed above, the resident loader running in the barcode printer 10 is responsive to the receipt of the transient loader application from the host computer 58 to store the transient loader in the RAM 54 of the barcode printer 10. The host computer proceeds from block 134 to block 136 where it sends a query to the barcode printer 10 to determine the printer's running state. If the host computer 58 determines at block 138 that the transient loader is not running in the barcode printer 10, the host computer 58 proceeds to block 140 to trigger an error event via the error event handler. When an error event is triggered, the host computer 58 proceeds to block 150 shown in Fig. 5B to display an error message to the user of the host computer. If the host computer determines at block 138 that the transient loader is running in the barcode printer 10, the host computer proceeds from block 138 to block 142. At block 142, the host computer 58 sends the QINIT command as discussed above to the barcode printer 10. At block 144, the host computer receives the INIT message from the barcode printer 10 indicating the manufacturer and identity of the flash memory 56 of the barcode printer 10. Thereafter, at block 146, the host computer reads the barcode printer's primary directory and stores it at the host computer as discussed in detail below with reference to Fig. 6. The primary directory of the barcode printer 10 identifies the items stored in the flash memory 56 and the location at which each item is stored in the flash memory 56. After reading the primary directory stored in the barcode printer's flash memory 56, the host computer proceeds to block 148 to process a file list containing the files to be reprogrammed into the barcode printer's flash memory 56 as discussed in detail with regard to Fig. 7.

The host computer 58 reads the primary flash directory stored in the flash memory 56 as shown in Fig. 6. At block 152, the host computer 58 initializes various variables. Thereafter, the host computer 58 at block 154 sends a read memory command identifying the location of the primary flash directory as discussed above with regard to the read memory command. At block 156, the host computer 58 receives a memory data message back from the barcode printer 10 wherein the memory data message includes an image of the printer's primary flash directory. Thereafter, at block 158, the host computer writes the received directory data to a local memory of the host computer 58. At block 160, the host computer utilizes the data contained in the received primary flash directory to update various variables used to reprogram individual items in the barcode printer's flash memory 56. Thereafter, at block 162, the host computer determines whether all of the data forming the printer's primary flash memory directory has been read and if not, the host computer returns to block 154 to send another read memory command. Once the printer's complete primary flash directory has been received, the host computer 58 proceeds to process the file list as shown in Fig. 7.

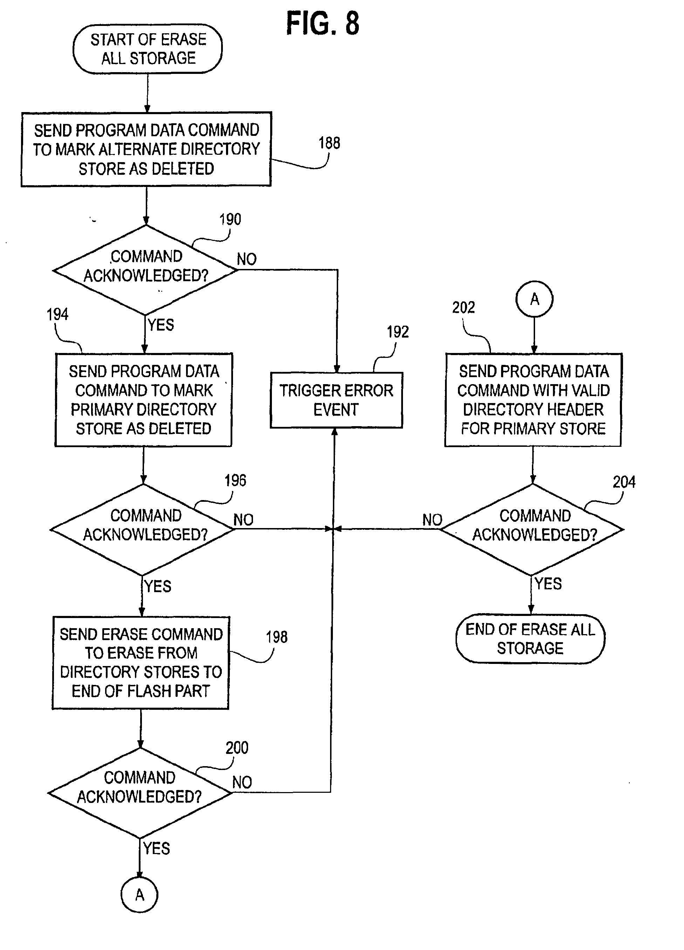

In order to process the file list, i.e. the list of files to be reprogrammed into the barcode printer's flash memory 56, the host computer 58 determines at block 164 whether the file list contains both the applications and all of the other individual items that can be reprogrammed into the flash memory 56. The file list will include applications and individual items including one or more font files and one or more print format files if the host computer 58 is to initially program the flash memory 56. If the list does contain one or more applications and all of the other individual items, the host computer proceeds to block 166 to erase the entire area of the flash memory 56 that is capable of being erased. Typically, this process includes erasing the entire flash memory 56 except for the area in the flash memory 56 at which the resident loader is stored. The erase all storage routine is depicted in Fig. 8.

As shown in Fig. 8, at the start of the erase all storage routine, the host computer 58 at block 188 sends a program data command to the barcode printer 10 in order to program a flag, in an alternate directory stored in the flash memory 56, as deleted. It is noted that the flash memory 56 includes a primary directory and an alternate directory both of which identify the individual items stored in the flash memory 56 and the location of those individual items in the memory. The use of a primary and alternate directory ensures that the directory information is not lost during the reprogramming operation if the barcode printer loses power, for example. From block 188, the host computer 58 proceeds to block 190 to determine whether the barcode printer 10 has acknowledged the successful execution of the program data command sent at block 188. If not, the host computer 58 proceeds from block 190 to block 192 to trigger an error event. If the program data command sent at block 188 was successfully executed, the host computer 58 proceeds to block 194. At block 194, the host computer 58 sends a program data command to the barcode printer 10 in order to mark a flag in the printer's primary directory as deleted. Thereafter, the host computer 58 determines at block 196 whether the program data command sent at block 194 has been acknowledged by the printer 10 as having been successfully completed. If not, the host computer proceeds from block 196 to block 192 to trigger an error event. If the program data command sent at block 194 was acknowledged by the barcode printer 10, the host computer 58 proceeds to block 198. At block 198, the host computer sends an erase command to erase the flash memory including the directory and all of the files that can be erased, i.e. all of the files except for the resident loader and any other file which cannot be reprogrammed or updated. From block 198, the host computer proceeds to block 200 to determine whether the erase command sent at block 198 has been acknowledged. If not, the host computer 58 proceeds to block 192 in order to trigger an error event. If the erase command sent at block 198 has been acknowledged by the barcode printer 10, the host computer 58 proceeds to block 202. At block 202, the host computer 58 sends a program data command to the barcode printer 10 wherein the program data command includes data defining a valid directory header for the primary directory. Thereafter, the host computer 58 proceeds to block 204 to determine whether the command sent at block 202 was acknowledged. If not, the host computer 58 proceeds to block 192 to trigger an error event. If the command has been acknowledged as determined at block 204, the host computer 58 returns to the flash process file list program depicted in Fig. 7 at a block 172.

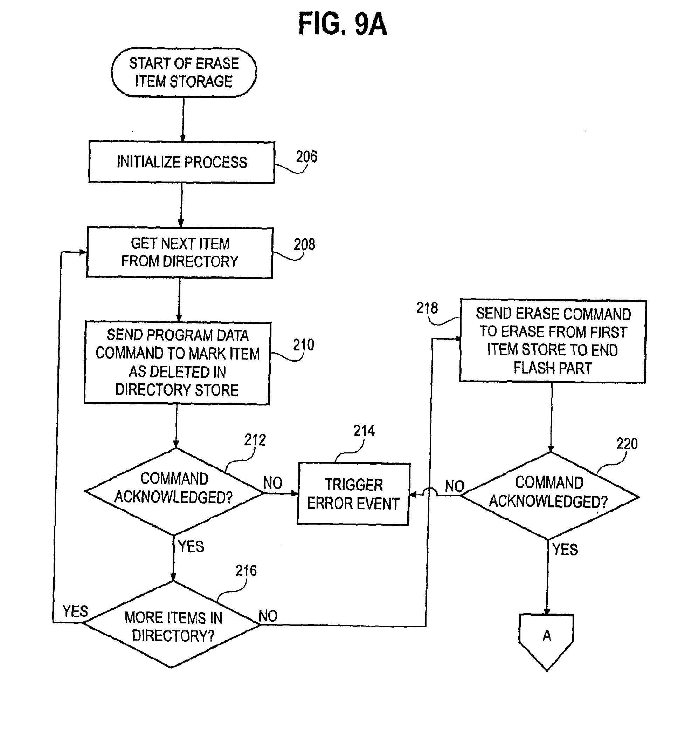

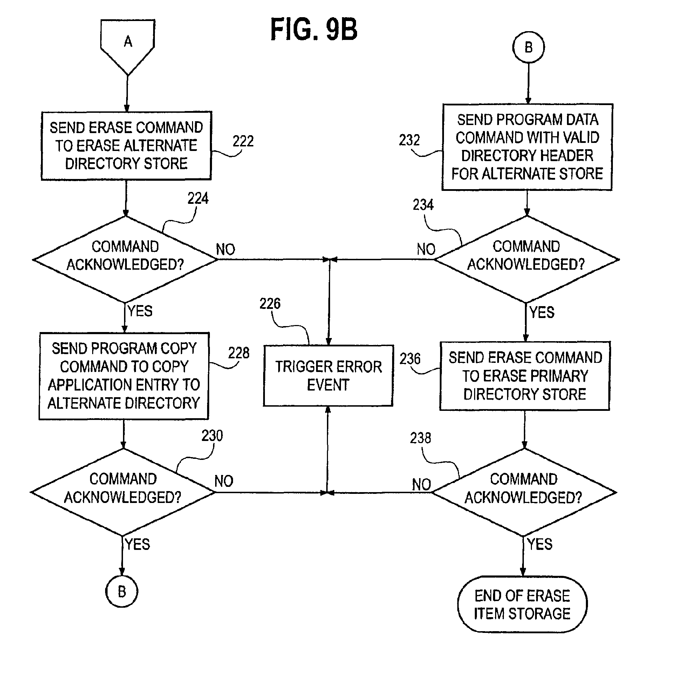

If the host computer 58 determines at block 164 that the file list does not contain applications and all of the individual items that can be programmed into the flash memory, the host computer proceeds to block 168. At block 168, the host computer 58 determines whether the file list contains individual items other than the applications and if so, the host computer proceeds to block 170. At block 170, the host computer executes the erase item storage routine depicted in Figs. 9A-B.

As shown in Figs. 9A-B, upon entering the erase item storage routine, the host computer 58 initializes this routine at block 206. Thereafter, the host computer 58 at block 208 gets the next item from the directory. At block 210, the host computer 58 sends a program data command to the barcode printer 10 in order to mark the next item in the directory as deleted. At block 212, the host computer 58 determines whether the program data command sent at block 210 has been acknowledged and if not, the host computer at block 214 triggers an error event. If the program data command sent at block 210 has been acknowledged, the host computer 58 at block 216 determines whether there are more items in the directory to be deleted and if so proceeds back to block 208. When the host computer 58 determines at block 216 that there are no more items in the directory that need to be marked as deleted, the host computer proceeds to block 218. At block 218 the host computer 58 sends an erase command to the barcode printer 10 in order to erase the items marked as deleted from the flash memory 56 of the barcode printer 10. At block 220, the host computer 58 determines whether the erase command sent at block 218 has been acknowledged and if not, the host computer 58 triggers an error event at block 214. If the erase command was acknowledged by the barcode printer 10, the host computer proceeds to a block 222 in order to send an erase command to erase the alternate directory stored in the flash memory 56 of the barcode printer 10. Thereafter, the host computer 58 proceeds to block 224 to determine whether the erase command sent at block 222 has been acknowledged and if not, the host computer 58 at block 226 triggers an error event. If the host computer 58 determines that the erase command sent at block 222 was acknowledged and successfully executed, the host computer 58 proceeds to block 228. At block 228, the host computer sends a program copy command in order to cause the barcode printer to copy the entry in the primary directory for the application(s) to the alternate directory in the flash memory 56 without copying the item directory. Thereafter, at block 230, the host computer 58 determines whether the program copy command sent at block 228 has been acknowledged and if not, the host computer triggers an error event at block 226. If the program copy command sent at block 228 has been acknowledged by the barcode printer 10, the host computer 58 proceeds from block 230 to block 232. At block 232, the host computer sends a program data command to the barcode printer 10 with data including a valid directory header for the alternate directory. At block 234, the host computer 58 determines whether the program data command sent at block 232 has been acknowledged and if not, the host computer triggers an error event at block 226. If the program data command sent at block 232 has been acknowledged, the host computer proceeds to block 236 to send an erase command to erase the primary directory stored. At this point, the alternate directory includes an entry for the application which is not to be reprogrammed and the alternate directory is set up to be programmed with the identity and location of new items to be programmed into the flash memory 56. At block 238, the host computer 58 determines whether the send erase command sent at block 236 has been acknowledged and if not, the host computer proceeds to block 226 to trigger an error event. If the erase command sent at block 236 has been acknowledged, the host computer 58 proceeds from block 238 back to the process file list routine depicted in Fig. 7 at block 172.

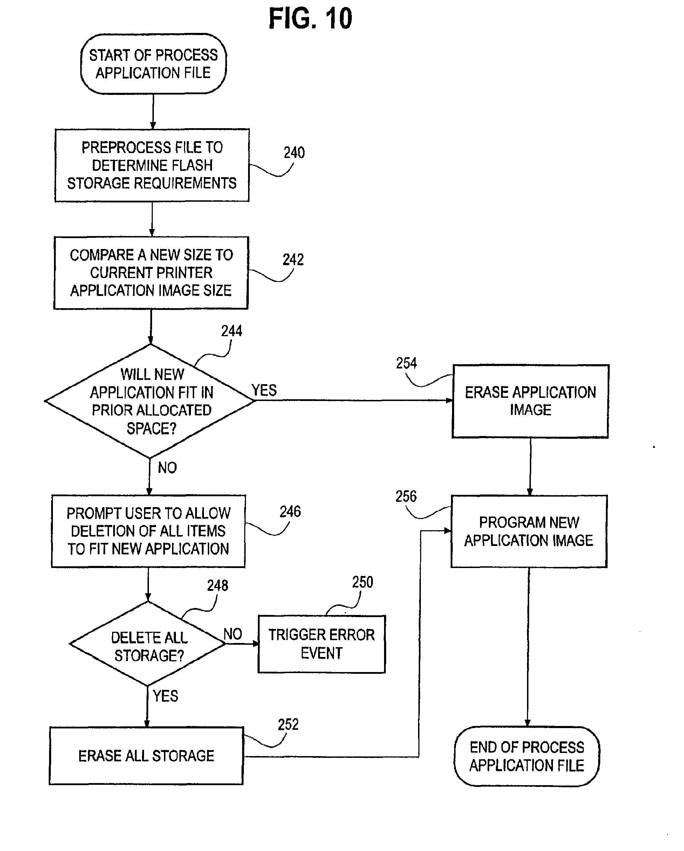

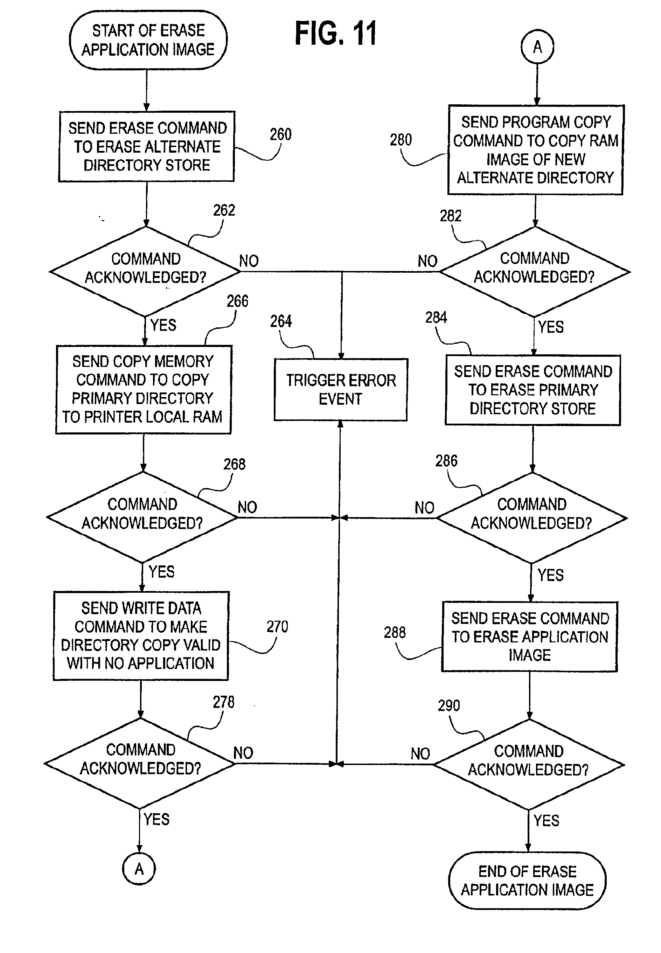

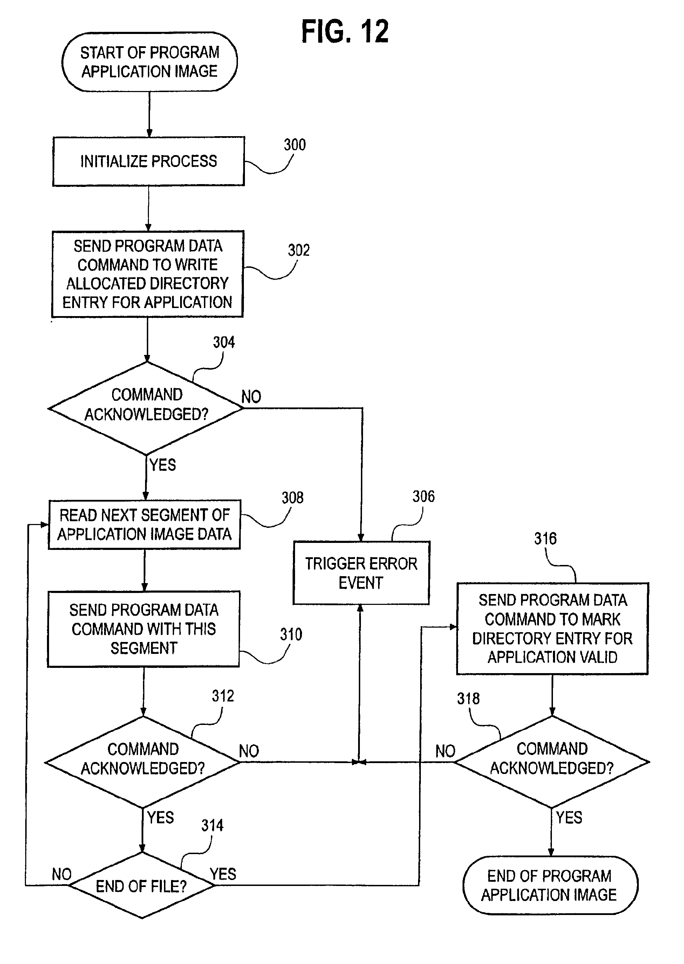

The host computer 58 at block 172 gets the next file from the list of files to be programmed into the flash memory 56 of the barcode printer 10. Thereafter, the host computer 58 proceeds to block 174 to determine whether the file is an application file. If it is, the host computer 58 proceeds to block 176 to process the application file as depicted in Figs. 10-12. As shown in Fig. 10, the host computer 58 at block 240 pre-processes the file to be programmed into the flash memory 56 of the barcode printer 10 in order to determine the storage requirements in the flash memory for the file. Thereafter, at block 242, the host computer compares the size of the new application to be programmed to the size of the current application stored in the flash memory 56 of the barcode printer 10. At block 244, the host computer 58 determines whether the new application file will fit in the area in the flash memory in which the current printer application is stored. If not, the host computer proceeds to block 246 to prompt the user to allow deletion of other items stored in the flash memory 56 in order to fit the new application file. The host computer 58 determines at block 248 whether the user has indicated that all of the storage should be deleted in order to accommodate the new application file and if not, proceeds to block 250 to trigger an error event. If the user has indicated that the necessary area in the flash memory to accommodate the new application file has been indicated by the user to be deleted, the host computer 58 proceeds to block 252 to execute the erase all storage routine. If the host computer 58 determines at block 244 that the new application will fit in the area of the flash memory 56 that was allocated to the prior application program, the host computer proceeds from block 244 to block 54 to erase only the application image stored in the flash memory 56 as discussed in detail below with respect to Fig. 11. After erasing only the application file in the flash memory 56 at block 254, the host computer 58 proceeds to block 256 to program a new application image into the flash memory 56 of the barcode printer 10 as described in detail below with respect to the routine depicted in Fig. 12.

At the start of the erase application image routine depicted in Fig. 11, the host computer 58 at block 260 sends an erase command to the barcode printer 10 in order to erase the alternate directory store. At block 262, the host computer 58 determines whether the erase command sent at block 260 has been acknowledged and if not, the host computer at block 264 triggers an error event. If the host computer 58 determines that the erase command sent at block 260 was acknowledged by the barcode printer 10, the host computer 58 proceeds from block 262 to block 266. At block 266, the host computer sends a copy memory command to the barcode printer 10 in order to copy the primary directory for the flash memory 56 that identifies the old or current application stored in the flash memory 56 to the printer's RAM 54. Thereafter, the host computer 58 determines whether the command sent at block 266 has been acknowledged by the barcode printer 10 and if not, the host computer 58 triggers an error event at block 264. If the host computer 58 determines that the copy memory command sent at block 266 has been acknowledged, the host computer 58 proceeds to block 270. At block 270, the host computer sends a write data command to the barcode printer 10 in order to make the directory copy valid with no application by re-writing the directory in the RAM 54 without the old, i.e. current application identified therein. At block 278, the host computer 58 determines whether the write data command sent at block 270 has been acknowledged and if not, the host computer at block 264 triggers an error event. If the host computer 58 determines at block 278 that the write data command sent at block 270 was acknowledged as having been successfully executed by the barcode printer 10, the host computer 58 proceeds to block 280. At block 280, the host computer 58 sends a program copy command to copy the image stored at block 270 in the RAM 54 into the flash memory 56 as the new alternate directory. At this point, the new alternate directory stored in the flash memory 56 is the same as the old directory without the old application file identified therein but including a directory of the other individual items which are to remain unchanged. At a block 282, the host computer determines whether the program copy command sent at block 280 has been acknowledged by the barcode printer 10 and if not, the host computer 58 at block 264 triggers an error event. If the program copy command sent at block 280 has been acknowledged by the barcode printer 110 as having been successfully executed, the host computer proceeds from block 282 to block 284. At block 284, the host computer sends an erase command to the barcode printer 10 in order to erase the primary directory stored in the flash memory 56. Thereafter, the host computer 58 determines whether the command sent at block 284 has been acknowledged and if not, the host computer triggers an error event at block 264. If the erase command sent at block 284 has been acknowledged by the barcode printer 10, the host computer 58 proceeds to block 288 to send an erase command to the barcode printer 10 in order to erase the old application image from the flash memory 56. If the host computer 58 determines at block 290 that the erase command sent at block 288 has been acknowledged by the barcode printer 10, the host computer proceeds to program the new application image into the flash memory 56 of the barcode printer 10 as described below with respect to Fig. 12.

At the start of the program application image routine shown in Fig. 12., the host computer at block 300 initializes the routine. Thereafter, at block 302 the host computer 58 sends a program data command to the barcode printer 10 in order to program a directory entry for the application program into the flash memory 56. At block 304, the host computer determines whether the program data command sent at block 302 has been acknowledged and if not, the host computer at block 306 triggers an error event. If the program data command sent at block 302 has been acknowledged by the barcode printer 10, the host computer proceeds from block 304 to block 308. At block 308, the host computer 58 reads the next segment of application image data from the host computer's local memory. Thereafter, at a block 310, the host computer formats and sends a program data command with the segment of application information read at block 308. At block 312, the host computer 58 determines whether the program data command containing the application segment sent at block 310 has been acknowledged and if not, the host computer at block 306 triggers an error event. If the host computer 58 determines at block 312 that the program data command sent at block 310 has been acknowledged, i.e. successfully executed by the barcode printer 10, the host computer 58 proceeds from block 312 to block 314. At block 314, the host computer determines whether the end of the application file has been reached and if not, the host computer returns to block 308 to send the next segment of application information in a program data command. This process continues until the host computer 58 determines at block 314 that the entire application image has been successfully programmed into the host computer's flash memory 56. Thereafter, the host computer at block 316 sends a program data command to the barcode printer 10 in order to mark the directory entry for the application as valid. At block 316, the host computer may also copy the directory to provide the alternate directory. At block 318, the host computer 58 determines whether the program data command sent to the barcode printer 10 at block 316 has been acknowledged and if not, the host computer at block 306 triggers an error event. If the host computer 58 determines at block 318 that the program data command sent at block 316 has been successfully executed by the barcode printer 10, the host computer returns to block 172 depicted in Fig. 7 to get the next file from the file list so that it can be programmed into the flash memory 56.

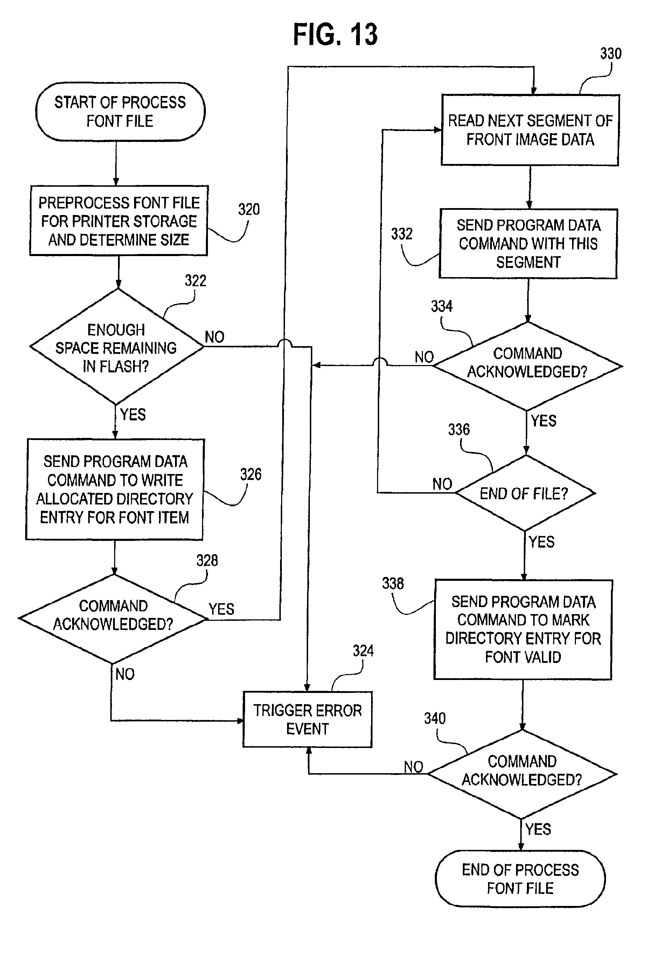

If the host computer 58 determines that the next file in the list to be reprogrammed into the flash memory 56 of the barcode printer 10 is a font file, the host computer proceeds from block 178 to block 180. At block 180, the host computer 58 executes a process font file routine as depicted in Fig. 13. At the start of the process font file routine, the host computer 58 at block 320 pre-processes the font file to determine the amount of storage in the printer's flash memory 56 needed to store the new font file. At block 322, the host computer 58 determines whether there is enough space remaining in the flash memory to store the new font file and if not, the host computer 58 at block 324 triggers an error event. If there is enough space remaining in the flash memory 56 of the barcode printer 10 to store the new font file, the host computer 58 proceeds from block 322 to block 326. At block 326, the host computer 58 sends a program data command to the barcode printer 10 in order to write a directory entry for the new font item in the flash memory 56 of the barcode printer 10. Thereafter, the host computer 58 determines at block 328 whether the program data command sent at block 326 has been acknowledged by the barcode printer 10 and if not, the host computer 58 at block 324 triggers an error event. If the program data command sent at block 326 is acknowledged by the barcode printer 10, the host computer 58 proceeds from block 328 to block 330. At block 330, the host computer 58 reads the next segment of font image data to be programmed into the printer's flash memory 56 from the local memory of the host computer 58. Thereafter, at block 332, the host computer 58 formats and sends a program data command containing the segment of font data read at block 330. At block 334, the host computer 58 determines whether the program data command sent at block 332 has been acknowledged by the barcode printer 10 and if not, the host computer 58 triggers an error event at block 324. If the program data command sent at block 332 has been acknowledged as successfully executed by the barcode printer 10, the host computer 58 proceeds from block 334 to block 336. At block 336, the host computer 58 determines whether the end of the new font file has been reached. If not, the host computer 58 returns to blocks 330 and 332 to send the next segment of font data in the font file so that it can be programmed into the printer's flash memory 56. When the host computer 58 detects the end of the font file at block 336, the host computer proceeds to block 338. At block 338, the host computer sends a program data command to the barcode printer 10 in order to mark the directory entry for the new font programmed into the flash memory 56 as valid. At block 340, the host computer 58 determines whether the program data command sent at block 338 has been acknowledged and if not, the host computer 58 triggers at block 324 an error event. If the program data command sent at block 338 has been acknowledged as having been successfully executed by the barcode printer 10 as determined at block 340, the host computer 58 returns to block 172 of Fig. 7.

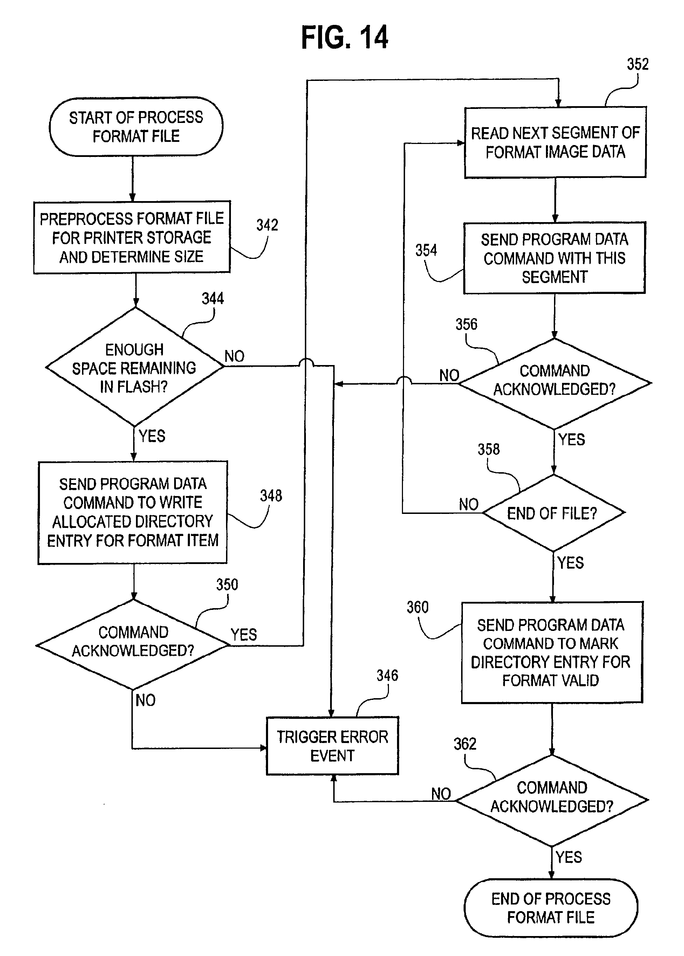

If the host computer 58 determines at block 182 shown in Fig. 7 that the next file in the list of files to be programmed into the printer's flash memory 56 is a print format file, the host computer 58 proceeds to block 184 to execute a process format file routine as depicted in Fig. 14. As shown in Fig. 14, at the start of the process format file, the host computer 58 at block 342 pre-processes the format file to determine the amount of storage in the flash memory 56 of the barcode printer 10 necessary to store the format file. At block 344, the host computer 58 determines whether there is enough space remaining in the flash memory 56 of the barcode printer in order to store the new format file and if not, the host computer 58 triggers an error event at block 346. If the host computer 58 determines at block 344 that there is enough space remaining in the flash memory to store the new format file, the host computer proceeds from block 344 to block 348. At block 348, the host computer 58 sends a program data command to the barcode printer 10 in order to program a directory entry for the new format item in the printer's flash memory 56. Thereafter, at block 350, the host computer 58 determines whether the program data command sent at block 348 has been acknowledged by the barcode printer 10 and if not, the host computer 58 at block 346 triggers an error event. If the program data command sent at block 348 has been acknowledged by the barcode printer 10 to have been successfully executed, the host computer proceeds from block 350 to block 352. At block 352, the host computer 58 reads from its local memory the next segment of format data to be programmed into the printer's flash memory 56. Thereafter, at block 354, the host computer 58 sends to the barcode printer 10 a program data command containing the segment of format data read at block 352. At block 356, the host computer 58 determines whether the program data command sent at block 354 has been acknowledged by the barcode printer 10, and if not, the host computer 58 triggers an error event at block 346. If the program data command sent at block 354 has been acknowledged by the barcode printer 10 as having been successfully executed, the host computer proceeds from block 356 to block 358. At block 358, the host computer 58 determines whether the end of the format file has been reached and if not, the host computer 58 proceeds back to blocks 352 and 354 to send a program data command with the next segment of the format file to be programmed into the printer's flash memory 56. Once the end of the format file has been detected at block 358, the host computer 358 proceeds to block 360 to send a program data command to the barcode printer 10 in order to mark the directory entry for the new format programmed into the flash memory 56 as valid. Thereafter, at block 362, the host computer determines whether the barcode printer 10 has acknowledged the program data command sent at block 36 and if not, the host computer 58 at block 346 triggers an error event. If the host computer 58 determines at block 362 that the program data command sent at block 360 has been successfully executed so that the programming of the new format file in the printer's flash memory 56 has been completed, the host computer 58 returns to the routine depicted in Fig. 7. The host computer 58 continues to program or reprogram individual items in the printer's flash memory 56 as shown in Fig. 7 until the host computer 58 determines that the end of the file list has been reached at block 186. When the end of the file list has been detected, the host computer exits the flash process file list routine.

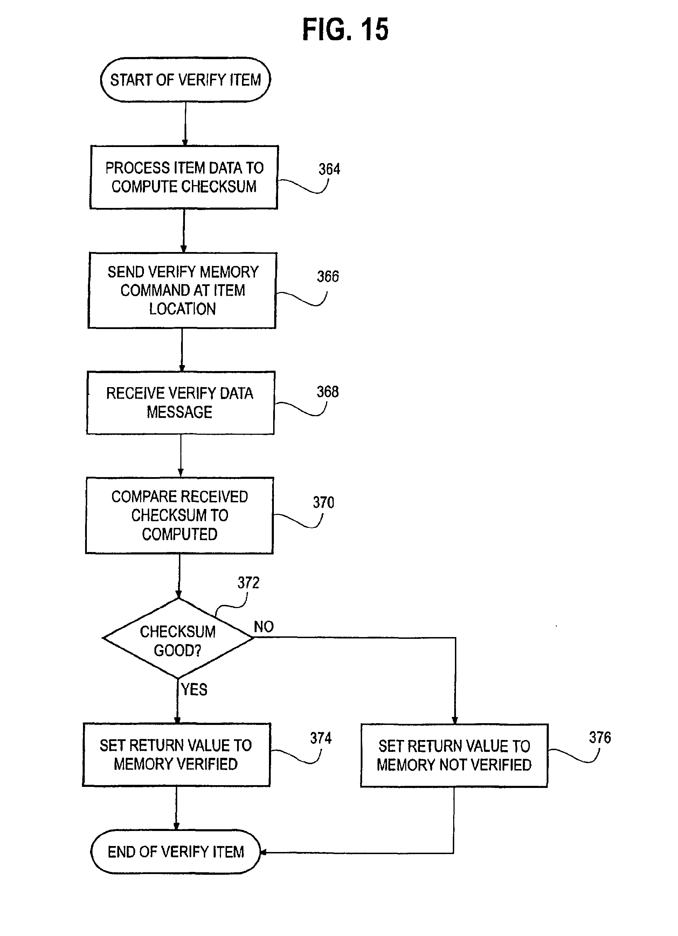

Fig. 15 illustrates a routine executed by the host computer 58 in order to verify the printer's flash memory 56. At the start of this routine, the host computer 58 processes data defining an item(s) in order to compute a checksum. Thereafter, at block 366, the host computer 58 sends a verify memory command to the barcode printer 10 identifying the location of the item(s) in the flash memory 56. At block 368 the host computer 58 receives a verify data message from the barcode printer 10 as discussed above and at block 370 the host computer 58 compares the checksum data includes in the verify data message received from the barcode printer 10 to the checksum computed by the host computer at block 364 for the item(s) stored in the printer's flash memory 56. Thereafter, at block 372, the host computer 58 determines whether the checksum received at block 368 is the same as the checksum computed at block 364 and if so, the host computer 58 proceeds to block 374 to set a return value to indicate that the printer's flash memory 56 has been verified for the item(s). If the host computer 58 determines at block 372 that the checksum received from the host computer is not the same as the computed checksum, the host computer 58 proceeds from block 372 to block 376 to set the return value for the item(s) to memory not verified.

Many modifications and variations of the present invention are possible in light of the above teachings. Thus, it is to be understood that, within the scope of the appended claims, the invention may be practiced otherwise than as described hereinabove.

## Claims

1. A system for reprogramming a flash memory in a barcode printer having a flash memory and a random access memory under the control of a host computer in communication with the barcode printer comprising:
a control program according to which the host computer operates to control the reprogramming of individual items in the barcode printer's flash memory without having to reprogram all items, the items that can be reprogrammed individually including an application file, a font file or a print format file, wherein the host computer operating in accordance with the control program receives a directory of the flash memory from the barcode printer, the directory identifying items stored in the flash memory and the location at which the items are stored; and communicates an erase command identifying an area in the flash memory to be erased and at least one program command associated with each item to be programmed into the printer's flash memory, each program command including a data segment of a new item file and a location in the flash memory for the data segment; and
a loading program according to which the barcode printer operates to reprogram the flash memory in response to commands received from the host computer, the barcode printer in accordance with the loading program being responsive to an erase command to erase an area of the flash memory identified by the erase command and being responsive to a program command to reprogram an area of the flash memory with the data segment for a new item file received with the program command.

2. A system for reprogramming a flash memory in a barcode printer under the control of a host computer as recited in claim 1 wherein the barcode printer operating in accordance with a loading program communicates an acknowledgement message to the host computer upon a successful completion of each command received from the host.

3. A system for reprogramming a flash memory in a barcode printer under the control of a host computer as recited in claim 1 wherein the barcode printer operating in accordance with the loading program communicates a message to the host in response to each command received wherein the message is an acknowledgement of a valid command or an indication of an error.

4. A system for reprogramming a flash memory in a barcode printer under the control of a host computer as recited in claim 1 wherein the host computer operating in accordance with the control program communicates a copy command to the barcode printer that identifies a source address in one of the memories of the barcode printer, a destination address in one of the memories of the barcode printer and information representing an amount of data to be copied; and the loading program is responsive to a copy command received from the host to copy, beginning at the source address, the amount of data identified in the copy command to one of the memories beginning at the destination address.

5. A system for reprogramming a flash memory in a barcode printer under the control of a host computer as recited in claim 1 wherein the host computer operating in accordance with the control program prompts the user to allow deletion of one or more items in the flash memory if the computer determines that there is not sufficient available area in the flash memory to store the new file.

6. A system for reprogramming a flash memory in a barcode printer under the control of a host computer as recited in claim 1 wherein the host computer operating in accordance with the control program communicates to the barcode printer a command to the barcode printer to compute a checksum for a specified portion of the flash memory, the memory including a starting address and an amount of data to be included in the checksum computation and the barcode printer operating in accordance with the loading program being responsive to the checksum command to compute a checksum value and to communicate the checksum to the host computer for verification.

7. A system for reprogramming a flash memory in a barcode printer under the control of a host computer as recited in claim 1 wherein the flash memory stores a directory identifying the items stored in the flash memory and the host computer operating in accordance with the control program controls the reprogramming of the directory prior to reprogramming an item stored in the flash memory.

8. A system for reprogramming a flash memory in a barcode printer under the control of a host computer as recited in claim 1 wherein the host computer controls the reprogramming of the directory by communicating at least one copy command to the barcode printer to control the barcode printer to copy at least the portion of the directory to remain unchanged to the random access memory; to erase a prior directory and to program a copy of the unchanged portion of the directory from the random access memory into the flash memory.

9. A system for reprogramming a flash memory in a barcode printer under the control of a host computer as recited in claim 1 wherein the loading program is stored in the random access memory of the host computer.

10. A method of reprogramming a flash memory in a barcode printer under the control of a host computer in communication with the barcode printer, the barcode including a random access memory and the method comprising:
communicating an erase command from the host computer to the barcode printer, the erase command identifying selective sectors to be erased by a starting address in the flash memory and information representing the amount of flash memory to be erased;
erasing the selected sectors in the flash memory of the barcode printer in response to the receipt of an erase command;
communicating an acknowledgement from the barcode printer to the host computer in response to successful completion of the erase command;
communicating a program command from the host computer to the barcode printer, the program command including a starting address and a segment of new data for an item to be reprogrammed in the flash memory;
reprogramming the flash memory with the segment of new data beginning at the starting address in the new data;
communicating an acknowledgement from the barcode printer to the host computer in response to successful completion of the program command; and
repeating the steps of communicating a program command, reprogramming the flash memory and communicating an acknowledgement of the completion of the program command for each segment of new data defining an individual item to be programmed in the flash memory to reprogram the individual item in the flash memory without the need to reprogram items that can be changed but are to remain unchanged.

11. A method of reprogramming a flash memory in a barcode printer under the control of a host computer as recited in claim 10 wherein one of said program commands reprograms an entry associated with the individual item in a directory stored in the flash memory and further including communicating a program command from the host computer to the barcode printer to mark the directory entry for the individual item as valid upon receipt of the program command acknowledgement for the last segment of new data reprogrammed into the flash memory for the individual item.

12. A method of reprogramming a flash memory in a barcode printer under the control of a host computer as recited in claim 10 wherein said flash memory includes a directory identifying individual items stored in the flash memory, the items stored including an application file; at least one font file or at least one print format file and including communicating a copy command from the host computer to the barcode printer to copy the directory to the random access memory; communicating a command from the host computer to the barcode printer to rewrite the directory without the items to be reprogrammed; communicating a command from the host computer to the barcode printer to program the rewritten directory into the flash memory; and communicating a command from the host computer to the barcode printer a command to program in the flash memory a new entry in the directory for the item to be reprogrammed.

13. A method of operating a host computer in communication with a barcode printer having a flash memory with a plurality of sectors and a random access memory, the method controlling the reprogramming of selective sectors of the barcode printer's flash memory from the host computer and comprising:
communicating to the barcode printer a plurality of commands executable by the barcode printer for reprogramming selected items in the flash memory including an application, a font and/or a print format, the plurality of commands including an erase command for erasing selected sectors in the flash memory; and a program command for reprogramming individual items in the flash memory without the need to reprogram items that can be changed but are to remain unchanged; and
receiving from the barcode printer, after communicating a command, an acknowledgement of the command after a successful completion of the command by the barcode printer or a status message if an error has occurred.

14. A method of operating a host computer in communication with a barcode printer having a flash memory with a plurality of sectors and a random access memory, the method controlling the reprogramming of selective sectors of the barcode printer's flash memory from the host computer and comprising:
communicating to the barcode printer a plurality of commands executable by the barcode printer for reprogramming selected items in the flash memory, the plurality of commands including an erase command for erasing selected sectors in the flash memory; a program command for reprogramming selected items in the flash memory; and a copy command for copying information from a location in one of the memories to another location in one of the memories; and
receiving from the barcode printer an acknowledgement of a command after a successful completion of the command by the barcode printer or a status message if an error has occurred.

15. A method of operating a barcode printer having a flash memory with a plurality of sectors and a random access memory to reprogram selective sectors of the flash memory under the control of a host computer comprising:
receiving a plurality of programming commands from the host computer including an erase command identifying a starting address in the flash memory at which erasing is to begin and information representing an amount of flash memory to be erased, and a plurality of program commands associated with an individual item to be programmed into the flash memory, each of the program commands including a starting address and a segment of data defining the new item; and
executing each command as it is received from the host computer to reprogram an individual item in the flash memory without the need to reprogram items that can be changed but are to remain unchanged.
